(19) Europäisches Patentamt
European Patent Office
Office européen des brevets

(11) **EP 2 874 178 B1**

(12) **EUROPEAN PATENT SPECIFICATION**

(45) Date of publication and mention of the grant of the patent:
**02.05.2018 Bulletin 2018/18**

(21) Application number: **13817110.3**

(22) Date of filing: **05.07.2013**

(51) Int Cl.:
*H01L 21/027* (2006.01)    *B41M 1/06* (2006.01)
*B41M 1/10* (2006.01)

(86) International application number:
**PCT/KR2013/006018**

(87) International publication number:
**WO 2014/010888 (16.01.2014 Gazette 2014/03)**

(54) **PRINTING PLATE FOR REVERSE OFFSET PRINTING AND METHOD FOR MANUFACTURING SAME**

DRUCKPLATTE FÜR UMGEKEHRTEN OFFSETDRUCK UND HERSTELLUNGSVERFAHREN DAFÜR

PLAQUE D'IMPRESSION POUR IMPRESSION OFFSET INVERSE ET SON PROCÉDÉ DE FABRICATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **11.07.2012  KR 20120075706**

(43) Date of publication of application:
**20.05.2015  Bulletin 2015/21**

(73) Proprietor: **LG Chem, Ltd.**
**Seoul 150-721 (KR)**

(72) Inventors:
• **KIM, Jooyeon**
  **Daejeon 305-380 (KR)**
• **LEE, Seung Heon**
  **Daejeon 305-380 (KR)**
• **KIM, Dae Hyun**
  **Daejeon 305-380 (KR)**
• **HWANG, Ji Young**
  **Daejeon 305-380 (KR)**

(74) Representative: **Goddar, Heinz J.**
**Boehmert & Boehmert**
**Anwaltspartnerschaft mbB**
**Pettenkoferstrasse 22**
**80336 München (DE)**

(56) References cited:
JP-A- 2006 188 054      JP-A- 2007 261 144
JP-A- 2010 089 442      JP-A- 2010 143 103
KR-A- 20080 071 774     KR-A- 20090 119 358
KR-A- 20100 072 969     KR-A- 20120 061 531
US-A1- 2009 283 000

EP 2 874 178 B1

## Description

[Technical Field]

The present application relates to a printing plate for reverse offset printing and a method for preparing the same, a printing device for reverse offset printing comprising the printing plate for reverse offset printing, and a method for forming a bezel pattern using the printing plate.

[Background Art]

In a display substrate, a photolithography method or a screen printing method has been used in order to form a bezel pattern in the related art, but in the case of the photolithography method, there is a problem in that a process for forming the pattern is complicated and the preparation costs thereof are expensive, and in the case of the screen printing method, there is a problem in performance due to the generation of cracks caused by high level differences.

Thus, there is a need for developing a method which is simpler than the method for forming a bezel pattern in the related art and may improve the performance thereof while reducing the costs thereof.

JP 2007261144 A, US2009/283000 A1, JP 2010143103 A, JP 2010089442 A and KR 20100072969 A disclose a printing plate for reverse offset printing comprising: intaglio portion corresponding to at least one bezel pattern, wherein a depth (D) of the intaglio portion satisfies equations 1 and 2 with respect to a blanket for a reverse offset printing, [Equation 1] $t < d < D$, [Equation 2] $t=t_{max}-t_{min}$, wherein in Equation 1, t means a thickness deviation of a blanket, d means a displacement value of a blanket thickness by blanket printing pressure, and d means an etching depth of an intaglio portion, and in Equation 2, $t_{max}$ means the maximum thickness of the blanket and $t_{min}$ means the minimum thickness of the blanket.

[Disclosure]

[Technical Problem]

The present application has been made in an effort to provide a printing plate for reverse offset printing which may form a bezel pattern of a display substrate such that the costs thereof may be reduced or the performance of the display substrate may be improved by improving the process efficiency or simplifying the processes thereof.

[Technical Solution]

The present application provides a printing plate for reverse offset printing comprising: an intaglio portion corresponding to at least one bezel pattern,

wherein a depth (D) of the intaglio portion satisfies the following Equations 1 and 2 with respect to a blanket for reverse offset printing,
wherein a line width (W) of the pattern satisfies the following Equation 3,
wherein the depth (D) is from 20 $\mu$m to 200 $\mu$m, and
wherein the line width (W) of the pattern is from 300 $\mu$m to 5 cm,

$$[\text{Equation 1}]$$

$$t < d < D$$

$$[\text{Equation 2}]$$

$$t = t_{max} - t_{min},$$

$$[\text{Equation 3}]$$

$$W = 2D + W_0,$$

in Equation 1, t means a thickness deviation of a blanket, d means a displacement value of a blanket thickness by blanket printing pressure, and D means an etching depth of an intaglio portion, and
in Equation 2, $t_{max}$ means the maximum thickness of the blanket and $t_{min}$ means the minimum thickness of the blanket,
in Equation 3, W means the line width of the pattern, D means an etching depth of an intaglio portion, and $W_0$ means a line width of opening of mask pattern.

The present application provides a reverse offset printing device including the printing plate for reverse offset printing.

Provided is a printed material which is prepared using the printing plate and includes a printing pattern corresponding to a bezel pattern of the printing plate.

Provided is a display substrate including the printed material.

Provided is an electronic device including the display substrate.

Provided is a method for forming a bezel pattern using the printing plate for reverse offset printing.

The present application provides a method for preparing a printing plate for reverse offset printing, the method comprising:

forming at least one mask pattern on a substrate; and
etching the substrate using the mask pattern,
wherein the mask pattern is a reverse image pattern of a bezel pattern, and
a depth (D) of the etched portion satisfies the following Equations 1 and 2 with respect to a blanket for reverse offset printing,

a line width (W) of the pattern satisfies the following Equation 3,
the depth (D) is from 20 $\mu$m to 200 $\mu$m, and
the line width (W) of the pattern is from 300 $\mu$m to 5 cm:

$$[\text{Equation 1}]$$

$$t < d < D$$

$$[\text{Equation 2}]$$

$$t = t_{max} - t_{min}$$

$$[\text{Equation 3}]$$

$$W = 2D + W_0,$$

in Equation 1, t means a thickness deviation of a blanket, d means a displacement value of a blanket thickness by blanket printing pressure, and D means an etching depth of an intaglio portion, and
in Equation 2, $t_{max}$ means the maximum thickness of the blanket and $t_{min}$ means the minimum thickness of the blanket,
in Equation 3, W means the line width of the pattern, D means an etching depth of an intaglio portion, and $W_0$ means a line width of opening of mask pattern.

In one embodiment, the mask pattern is formed of a material comprising one or two or more selected from the group consisting of chromium, nickel, molybdenum, an oxide thereof, and a nitride thereof.

[Advantageous Effects]

The printing plate for reverse offset printing according to the present application is effective for forming a bezel pattern of a display substrate.

[Description of Drawings]

FIG. 1 illustrates a reverse offset printing method.
FIG. 2 illustrates a side view of a printing plate for reverse offset printing in which a portion corresponding to a bezel pattern is formed as an intaglio portion.
FIG. 3 illustrates a plane view of a printing plate for reverse offset printing in which a portion corresponding to a bezel pattern is formed as an intaglio portion, when observed from the above.
FIG. 4 illustrates a bezel pattern transferred on an object to be printed.
FIG. 5 illustrates a thickness deviation of a blanket, in which $t_{max}$ means the maximum value of the blanket thickness and $t_{min}$ means the minimum value of the blanket thickness.
FIG. 6 illustrates a blanket and a printing plate, D is an etching depth of an intaglio portion, and d is a displacement value of the blanket thickness due to blanket printing pressure.
FIG. 7 illustrates a bottom touch phenomenon occurring when a printing composition applied on a blanket is transferred on a printing plate.
FIG. 8 illustrates the maximum thickness value of a blanket within an intaglio portion region which changes as the line width of the pattern increases.

[Mode for Invention]

The advantages and features of the present application, and methods of accomplishing the advantages and features will become obvious with reference to exemplary embodiments to be described below in detail along with the accompanying drawings. However, the present application is not limited to the exemplary embodiments to be disclosed below, but will be implemented in various forms different from each other. The exemplary embodiments are merely intended to make the disclosure of the present application complete and to completely notify the person with ordinary skill to which the present application pertains of the scope of the invention, and the present application is only defined by the scope of claims. The size and relative size of the constituent elements marked in the drawings may be exaggerated for clarity of description.

Unless otherwise defined, all terms including technical and scientific terms used in the present specification may be used as the meaning which may be commonly understood by the person with ordinary skill in the art to which the present application pertains. Terms defined in commonly used dictionaries should not be interpreted in an idealized or excessive sense unless clearly and particularly defined.

Hereinafter, the present application will be described in detail.

A "bezel" used in the present specification means at least one border portion included in a display substrate. The bezel may be included in a region other than an effective screen portion. Further, a sensor portion, a camera portion, a logo portion, a button portion, or an open portion may be included in the border portion region.

A "bezel pattern" used in the present specification means a pattern formed in the bezel portion. The bezel pattern may be included in other regions such as the sensor portion, the camera portion, the logo portion, the button portion, or the open portion. The bezel pattern may also be a design pattern or a black matrix pattern.

In the present application, a printing plate for reverse offset printing includes an intaglio portion corresponding to at least one bezel pattern. Specifically, a region of a portion corresponding to a bezel pattern may be formed as an engraving.

The printing plate includes an intaglio portion corresponding to at least one bezel pattern, and particularly, intaglio portions corresponding to a plurality of bezel patterns, and thus several patterns may be simultaneously formed, thereby improving process efficiency.

In an exemplary embodiment of the present application, the printing plate may include a relief portion which is a region other than the intaglio portion.

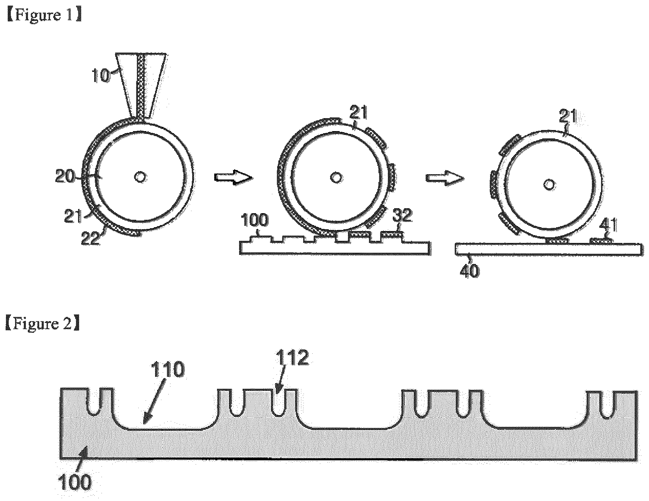

FIG. 2 illustrates a side view of a printing plate for reverse offset printing in which a portion corresponding to a bezel pattern is formed as an intaglio portion. In FIG 2, reference numeral 100 is a printing plate, reference numeral 110 is an intaglio portion corresponding to a bezel pattern, and reference numeral 112 is an align key.

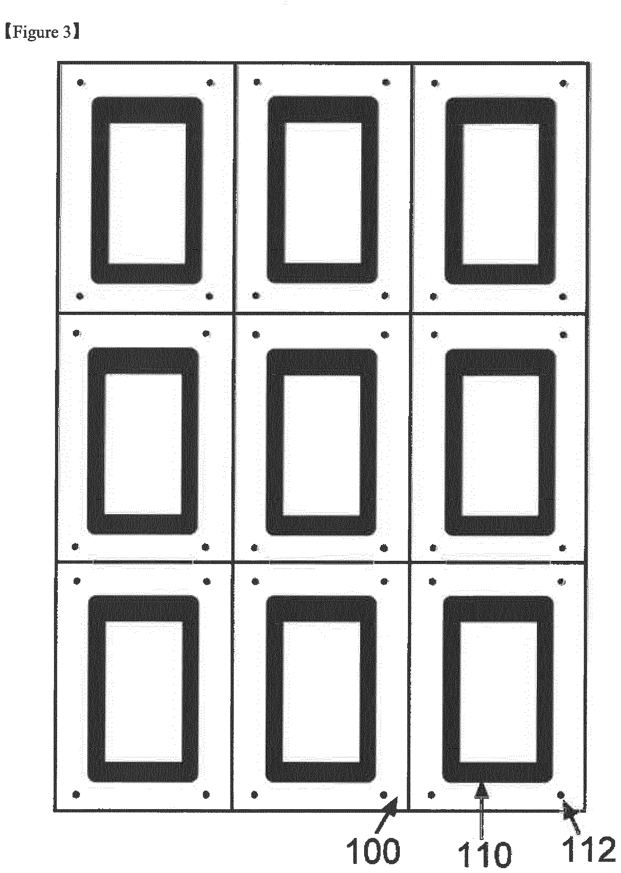

FIG. 3 illustrates a plane view of a printing plate for reverse offset printing in which a portion corresponding to a bezel pattern is formed as an intaglio portion, when observed from the above.

FIGS. 2 and 3 illustrate an example in which several bezel patterns are formed as an intaglio portion. Since a printing plate in which several bezel patterns are simultaneously formed is used, a plurality of bezel patterns may be simultaneously printed, thereby improving process efficiency and obtaining a cost reduction effect.

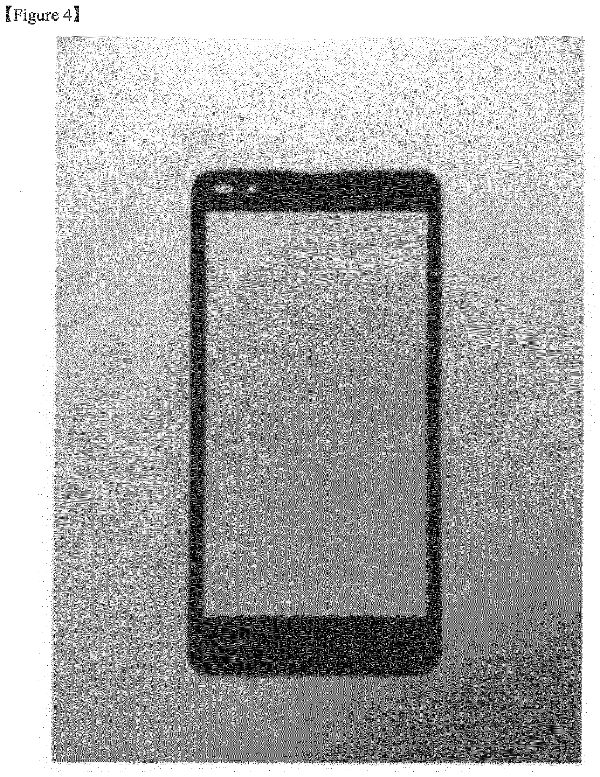

FIG. 4 illustrates a bezel pattern transferred on an object to be printed.

A "blanket" used in the present specification means a packing portion which surrounds a printing roll support, and a "blanket for reverse offset printing" means a blanket used in a reverse offset printing. The blanket may be used for removing ink in a portion which is in contact with a region other than the intaglio portion of the printing plate. That is, the blanket may be used for removing ink coated on the blanket which is in contact with the relief portion of the printing plate. The blanket may be used for removing ink on a portion which is in contact with a region other than an intaglio portion of a printing plate through contact with the printing plate after ink is coated on the entire surface of a blanket in a reverse offset printing device, and transferring a remaining pattern in the blanket on a substrate.

In an exemplary embodiment of the present application, the blanket may be specifically a silicone-based blanket. The silicone-based blanket means that an outer circumference portion of the blanket is composed of a silicone-based material. The silicone-based material is not particularly limited as long as the material is a material including a curable group while including silicone, but the hardness thereof is preferably from 20 to 70 and more preferably from 30 to 60. The hardness means Shore A hardness. The deformation in the blanket may occur within a suitable range by using a silicone-based material within the hardness range. When the hardness of the blanket material is too low, a phenomenon occurs in which a part of the blanket touches the intaglio portion of the printing plate due to the deformation in the blanket during the off process in which a part of the coating film of the printing composition is removed by a printing plate from the blanket, and thus the pattern precision may deteriorate. In addition, a material having a hardness of 70 or less may be selected by considering the easiness in selection of the blanket material.

For example, a polydimethyl siloxane (PDMS)-based curable material may be used as the silicone-based blanket material. Additives known in the art may be further included to the blanket material within the range of not impairing the object of the present invention.

In the present application, a depth (D) of the intaglio portion satisfies the following Equations 1 and 2 with respect to a blanket.

$$[\text{Equation 1}]$$

$$t < d < D$$

$$[\text{Equation 2}]$$

$$t = t_{max} - t_{min}$$

In Equation 1, t means a thickness deviation of the blanket, d means a displacement value of a blanket thickness by blanket printing pressure, and D means an etching depth of an intaglio portion.

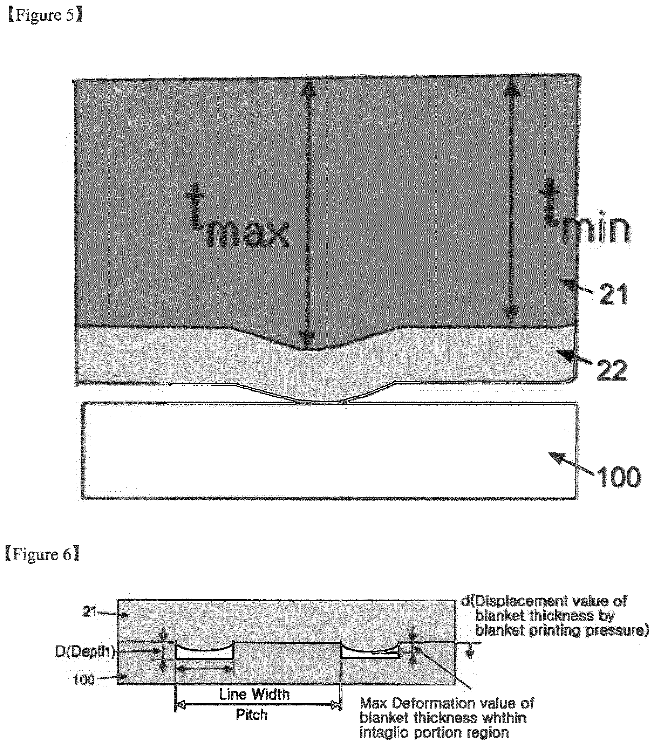

In Equation 2, $t_{max}$ means the maximum thickness of the blanket itself and $t_{min}$ means the minimum thickness of the blanket itself. FIG. 5 illustrates the thickness deviation of the blanket.

The unit of t, d, and D is $\mu$m.

In the present specification, the displacement value of the blanket thickness by blanket printing pressure means a displacement value of the blanket thickness generated by additionally applied pressure at a position in which the thickest portion ($t_{max}$) of the blanket begins to touch a printing plate.

FIG. 6 illustrates a blanket and a printing plate, D is an etching depth of an intaglio portion, and d is a displacement value of the blanket thickness by blanket printing pressure.

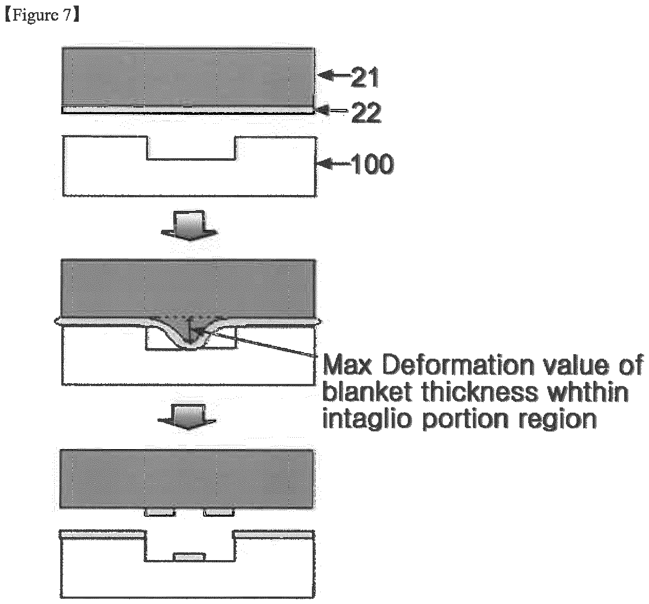

FIG. 7 illustrates a bottom touch phenomenon occurring when a printing composition applied on a blanket is transferred on a printing plate. In FIG. 7, reference numeral 21 is a blanket, reference numeral 22 is a printing composition, and reference numeral 100 is a printing plate.

In FIG. 7, when the maximum deformation value of a blanket thickness within an intaglio portion region approaches the D value, the bottom touch phenomenon occurs, thereby impairing the printing pattern. When the maximum deformation value of the blanket thickness within the intaglio portion region is less than the D value, the bottom touch phenomenon does not occur.

The thickness deviation of the blanket may be the maximum deformation value of the blanket thickness within an intaglio portion region as an example. The maximum deformation value of the blanket thickness within the intaglio portion region means the maximum deformation value among the deformation values of the blanket thickness within the intaglio portion region at the moment in which the blanket passes the intaglio portion when a printing roll passes a printing plate. The intaglio portion region may mean a region including a height from a point corresponding to the surface of a relief portion adjacent to any one intaglio portion to a point corresponding to the lowest point of the intaglio portion. Furthermore, the maximum deformation value of the blanket thickness within the intaglio portion region may mean a thickness from a point corresponding to the surface of a relief portion adjacent to any one intaglio portion to the lowest point of the blanket present within the intaglio portion region.

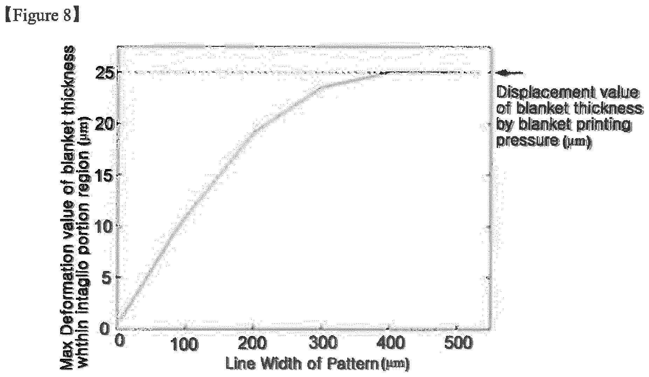

FIG. 8 illustrates the maximum deformation value of a blanket thickness within an intaglio portion region which changes as the line width of the pattern increases. Referring to FIG. 8, it can be confirmed that the maximum deformation value of the blanket thickness within an intaglio portion region is less than the deformation value of the blanket thickness by blanket printing pressure. Further, when the line width of the pattern is equal to or greater than a certain size, it can be confirmed that the maximum deformation value of the blanket thickness within an intaglio portion region converges on the displacement value of the blanket thickness by blanket printing pressure.

Thus, so long as the D value is larger than the displacement value of the blanket thickness by blanket printing pressure, the bottom touch phenomenon may not occur.

An exemplary embodiment of the present application provides a method for preparing a printing plate for reverse offset printing.

In the printing plate prepared by the preparing method according to an exemplary embodiment of the present application, the depth (D) of the intaglio portion satisfies Equations 1 and 2 with respect to a blanket for reverse offset printing.

The method for preparing a printing plate for reverse offset printing according to the present application includes forming at least one mask pattern on a substrate. The substrate may be a glass substrate.

The method for preparing a printing plate for reverse offset printing according to an the present application includes etching the substrate using the mask pattern.

In an exemplary embodiment of the present application, the mask pattern may be formed of a material including one or two or more selected from the group consisting of chromium, nickel, molybdenum, an oxide thereof, and a nitride thereof.

In the present application, the mask pattern is a reverse image pattern of a bezel pattern.

In the present application, the line width (W) of the pattern satisfies the following Equation 3.

[Equation 3]

$$W = 2D + W_0 + X$$

W: Line Width, D: Depth, X: Constant, $W_0$: Line Width of opening of mask pattern

In the present application, the line width (W) of the pattern is from 300 $\mu$m to 5 cm, due to characteristics of the bezel pattern.

In the present application, the depth (D) of the intaglio portion is from 20 $\mu$m to 200 $\mu$m. The depth from 20 $\mu$m to 200 $\mu$m may be a depth satisfying Equations 1 and 2, or a depth satisfying Equations 1 to 3. More specifically, the depth (D) of the intaglio portion may be from 80 $\mu$m to 120 $\mu$m, and more specifically 100 $\mu$m. When the depth of the intaglio portion satisfies Equations 1 and 2 and is from 20 $\mu$m to 200 $\mu$m, or satisfies Equations 1 to 3 and is from 20 $\mu$m to 200 $\mu$m, there is an effect in that the bottom touch does not occur.

A line height (height) of the printed bezel pattern according to an exemplary embodiment of the present application may be from 0.3 $\mu$m to 5 $\mu$m, specifically, from 0.3 $\mu$m to 3 $\mu$m, and more specifically from 0.5 $\mu$m to 2 $\mu$m. When a bezel pattern is printed using a screen printing method in the related art, the line height of the bezel pattern is 20 $\mu$m or more, and therefore, the level difference is high. Therefore, a bezel pattern of a touch panel is disadvantageous in that due to generation of cracks in the vicinity of a level difference of an ITO layer or a metal layer caused by the high level difference, a defect occurs and the yield is reduced. However, when the method of the present application is used, it is possible to implement a line height from 0.3 $\mu$m to 5 $\mu$m, and therefore, there is an advantage in that cracks are scarcely generated and as a result, the performance of the display may be improved.

The printing plate for reverse offset printing according to an exemplary embodiment of the present application may additionally include an align key on a region in which the bezel pattern is not provided.

In the printing plate for reverse offset printing according to an exemplary embodiment of the present application, a bottom touch phenomenon may not occur on an intaglio portion corresponding to the bezel pattern when ink is transferred on the printing plate.

The present application provides a method for forming a bezel pattern using a printing plate for reverse offset printing. FIG. 4 illustrates a bezel pattern transferred on an object to be printed when the bezel pattern is formed using a printing plate for reverse offset printing according to an exemplary embodiment of the present application. When a bezel pattern is formed using the printing plate for reverse offset printing according to the present application, the process efficiency may be greatly improved. The screen printing method in the related art has a problem in that the line height of the bezel pattern formed is large, and thus a high level difference is generated, and the generation of disconnections or cracks is highly possible in the vicinity of a level difference of an ITO layer or a metal layer when post-processing for adhering a sensor to a glass substrate is performed. Accordingly, a processing method for reducing a level difference has been used by forming a plurality of printing layers, but there is a problem in that the loss is too great in terms of process efficiency or costs. In addition, a photolithography method used as another method also has a problem in that the loss is too great in terms of process efficiency or costs. However, when a bezel pattern is formed using the printing plate for reverse offset printing according to the present application, there is an advantage in that the process efficiency may be achieved because a plurality of bezel patterns may be simultaneously formed and a simple method is used.

Provided is a printing device for reverse offset printing including a printing plate for reverse offset printing.

The printing device for reverse offset printing may further include a blanket and a printing roll support that supports the blanket. The printing device for reverse offset printing may further include a coater which coats ink on a blanket.

FIG. 1 illustrates a reverse offset printing method. In FIG 1, reference numeral 10 is a coater which coats a metal pattern material on the blanket, reference numeral 20 is a printing roll support for supporting a blanket, reference numeral 21 is a blanket, and reference numeral 22 is a printing composition pattern material applied on the blanket. Reference numeral 100 is a printing plate having a pattern, and a pattern corresponding to a pattern to be formed is formed as an engraving. Reference numeral 40 is an object to be printed, and reference numeral 41 is a bezel pattern of a printing composition pattern transferred to an object to be printed.

Provided is a printed material which is prepared using the reverse offset printing device and includes a bezel pattern corresponding to an intaglio portion of the printing plate. The intaglio portion of the printing plate means an intaglio portion corresponding to the bezel pattern. The bezel pattern included in the printed material means a pattern printed on the printed material. Provided is a printed material which is prepared using the reverse offset printing device and includes a printing pattern corresponding to a bezel pattern of the printing plate.

Provided is display substrate including the printed material. Examples of the display device include a plasma display panel (PDP), a liquid crystal display (LCD) panel, an electrophoretic display panel, a cathoderay tube (CRT) panel, an OLED display panel, or various touch panels, and the like.

Provided is an electronic device including the display substrate.

Provided is a method for forming a bezel pattern using the cliche for reverse offset printing.

An exemplary embodiment of the present application provides a method for forming a bezel pattern using the reverse offset printing device.

Hereinafter, the present application will be described in more detail through Examples. However, the following Examples are provided for illustrative purposes only, and the scope of the present application is not limited thereby.

<Example 1>

When a displacement value of a blanket thickness by blanket printing pressure was set to 25 μm, the maximum thickness value of a blanket within an intaglio portion region of a pattern was computer-simulated at an upper portion of the intaglio portion region of the pattern. As a line width of the pattern was increased, the maximum thickness value of the blanket within the intaglio portion region was increased, but it could be confirmed that the value was a value less than a displacement value of the blanket thickness by blanket printing pressure. Furthermore, in a line width of 300 μm or more, it could be confirmed that the maximum thickness value of the blanket within the intaglio portion region converged on the displacement value of the blanket thickness by blanket printing pressure. FIG. 8 illustrates the result.

Thus, it can be seen that a bottom touch effect does not occur as long as the etching depth of the intaglio portion is more than 25 μm when the printing pressure is set to 25 μm.

<Example 2>

When a displacement value of a blanket thickness by blanket printing pressure was set to 50 μm, the maximum thickness value of a blanket within an intaglio portion region of a pattern was computer-simulated at an upper portion of the intaglio portion region of the pattern. As a line width of the pattern was increased, the maximum thickness value of the blanket within the intaglio portion region was increased, but it could be confirmed that the value was a value less than a displacement value of the blanket thickness by blanket printing pressure. Further, in a line width of 300 μm or more, it could be confirmed that the maximum thickness value of the blanket within the intaglio portion region converged on the displacement value of the blanket thickness by blanket printing pressure. Thus, it can be seen that a bottom touch effect does not occur as long as the etching depth of the intaglio portion is more than 50 μm when the printing pressure is set to 50 μm.

It is understood by a person with ordinary skill in the art to which the present application pertains that various applications and modifications may be made within the scope of the present application based on the contents.

[Description of Reference Numerals]

10: Coater
20: Printing roll support
21: Blanket
22: Printing composition
32: Printing composition
40: Object to be printed
41: Bezel pattern of a printing composition
100: Printing plate
110: Intaglio portion corresponding to a bezel pattern
112: Align key

## Claims

1. A printing plate for reverse offset printing comprising:
an intaglio portion corresponding to at least one bezel pattern,
wherein a depth (D) of the intaglio portion satisfies the following Equations 1 and 2 with respect to a blanket for reverse offset printing,
wherein a line width (W) of the pattern satisfies the following Equation 3,
wherein the depth (D) is from 20 $\mu$m to 200 $\mu$m, and
wherein the line width (W) of the pattern is from 300 $\mu$m to 5 cm,

$$[\text{Equation 1}]$$

$$t < d < D$$

$$[\text{Equation 2}]$$

$$t = t_{max} - t_{min},$$

$$[\text{Equation 3}]$$

$$W = 2D + W_0,$$

in Equation 1, t means a thickness deviation of a blanket, d means a displacement value of a blanket thickness by blanket printing pressure, and D means an etching depth of an intaglio portion, and
in Equation 2, $t_{max}$ means the maximum thickness of the blanket and $t_{min}$ means the minimum thickness of the blanket,
in Equation 3, W means the line width of the pattern, D means an etching depth of an intaglio portion, and $W_0$ means a line width of opening of mask pattern.

2. A printing device for reverse offset printing, comprising the printing plate for reverse offset printing of claim 1.

3. A method for forming a bezel pattern using the printing plate for reverse offset printing of claim 1.

4. A method for preparing a printing plate for reverse offset printing, the method comprising:

forming at least one mask pattern on a substrate; and
etching the substrate using the mask pattern, wherein the mask pattern is a reverse image pattern of a bezel pattern, and
a depth (D) of the etched portion satisfies the following Equations 1 and 2 with respect to a blanket for reverse offset printing,

a line width (W) of the pattern satisfies the following Equation 3,
the depth (D) is from 20 $\mu$m to 200 $\mu$m, and
the line width (W) of the pattern is from 300 $\mu$m to 5 cm:

$$[\text{Equation 1}]$$

$$t < d < D$$

$$[\text{Equation 2}]$$

$$t = t_{max} - t_{min}$$

$$[\text{Equation 3}]$$

$$W = 2D + W_0,$$

in Equation 1, t means a thickness deviation of a blanket, d means a displacement value of a blanket thickness by blanket printing pressure, and D means an etching depth of an intaglio portion, and
in Equation 2, $t_{max}$ means the maximum thickness of the blanket and $t_{min}$ means the minimum thickness of the blanket,
in Equation 3, W means the line width of the pattern, D means an etching depth of an intaglio portion, and $W_0$ means a line width of opening of mask pattern.

5. The method of claim 4, wherein the mask pattern is formed of a material comprising one or two or more selected from the group consisting of chromium, nickel, molybdenum, an oxide thereof, and a nitride thereof.

## Patentansprüche

1. Druckplatte für umgekehrten Offset-Druck, umfassend: einen Tiefdruckbereich, korrespondierend zu wenigstens einem Einfassungsmuster,
wobei eine Tiefe (D) des Tiefdruckbereichs die folgenden Gleichungen 1 und 2 in Bezug auf einen Mantel für umgekehrten Offset-Druck erfüllt,
wobei eine Linienbreite (W) des Musters die folgende Gleichung 3 erfüllt,
wobei die Tiefe (D) von 20 μm bis 200 μm ist,
wobei die Linienbreite (W) des Musters von 300 μm bis 5 cm ist,

[Gleichung 1]

$$t < d < D$$

[Gleichung 2]

$$t = t_{max} - t_{min},$$

[Gleichung 3]

$$W = 2D + W_0,$$

wobei in Gleichung 1 t eine Dickenabweichung eines Mantels bedeutet, d einen Verdrängungswert einer Manteldicke durch Mantelbedruckungsdruck bedeutet, und D eine Ätztiefe eines Tiefdruckbereichs bedeutet, und
in Gleichung 2 $t_{max}$ die maximale Dicke des Mantels bedeutet und $t_{min}$ die minimale Dicke des Mantels bedeutet,
in Gleichung 3 W die Linienbreite des Musters bedeutet, D eine Ätztiefe eines Tiefdruckbereichs bedeutet und $W_0$ eine Linienbreites eines Öffnens eines Maskenmusters bedeutet.

2. Druckvorrichtung zum umgekehrten Offset-Druck, umfassend die Druckplatte für umgekehrten Offset-Druck nach Anspruch 1.

3. Verfahren zum Bilden eines Einfassungsmusters unter Verwendung der Druckplatte zum umgekehrten Offset-Druck nach Anspruch 1.

4. Verfahren zum Herstellen einer Druckplatte zum umgekehrten Offset-Druck, wobei das Verfahren umfasst:

Bilden wenigstens eines Maskenmusters auf einem Substrat; und
Ätzen des Substrats unter Verwendung des Maskenmusters,
wobei das Maskenmuster ein umgekehrtes Bildmuster eines Einfassungsmusters ist, und
eine Tiefe (D) des geätzten Bereichs die folgenden Gleichungen 1 und 2 in Bezug auf einen Mantel zum umgekehrten Offset-Druck erfüllt,
eine Linienbreite (W) des Musters die folgende Gleichung 3 erfüllt,
die Tiefe (D) von 20 μm bis 200 μm ist, und
die Linienbreite (W) des Musters von 300 μm bis 5 cm ist:

[Gleichung 1]

$$t < d < D$$

[Gleichung 2]

$$t = t_{max} - t_{min},$$

[Gleichung 3]

$$W = 2D + W_0,$$

wobei in Gleichung 1 t eine Dickenabweichung eines Mantels bedeutet, d einen Verdrängungswert einer Manteldicke durch Mantelbedruckungsdruck bedeutet, und D eine Ätztiefe eines Tiefdruckbereichs bedeutet, und
in Gleichung 2 $t_{max}$ die maximale Dicke des Mantels bedeutet und $t_{min}$ die minimale Dicke des Mantels bedeutet,
in Gleichung 3 W die Linienbreite des Musters bedeutet, D eine Ätztiefe eines Tiefdruckbereichs bedeutet und $W_0$ eine Linienbreites eines Öffnens eines Maskenmusters bedeutet.

5. Verfahren nach Anspruch 4, wobei das Maskenmuster gebildet wird aus einem Material umfassend eines oder zwei oder mehrere ausgewählt aus der Gruppe bestehend aus Chrom, Nickel, Molybdän, einem Oxid derselben und einem Nitrid derselben.

**Revendications**

1. Plaque d'impression pour impression offset inverse comportant: une partie en creux correspondant au moins à une configuration d'encadrement,
où la profondeur (D) de la partie en creux satisfait les Equations 1 et 2 suivantes par rapport à un blanchet pour l'impression offset inverse,
où la largeur de ligne (W) de l'encadrement satisfait l'Equation 3 suivante,
où la profondeur (D) est comprise entre 20 $\mu$m et 200 $\mu$m, et
où la largeur de ligne (W) de la configuration est comprise entre 300 $\mu$m et 5 cm,

[Equation 1]
$$t < d < D$$

[Equation 2]
$$t = t_{max} - t_{min},$$

[Equation 3]
$$W = 2D + W_0$$

dans l'Equation 1, t représente l'écart d'épaisseur d'un blanchet, d représente la valeur du déplacement de l'épaisseur du blanchet par la pression d'impression du blanchet, et D représente la profondeur de gravure de la partie en creux, et aussi
dans l'Equation 2, $t_{max}$ représente l'épaisseur maximum du blanchet et $t_{min}$ représente l'épaisseur minimum du blanchet,
dans l'Equation 3, W représente la largeur de ligne de la configuration, D représente la profondeur de gravure d'une partie en creux, et $W_0$ représente une largeur de ligne de l'ouverture de la configuration du masque.

2. Diapositif d'impression pour impression offset inverse, comportant la plaque d'impression pour impression offset inverse selon la revendication 1.

3. Procédé de formation d'une configuration d'encadrement à l'aide de la plaque d'impression pour impression offset inverse selon la revendication 1.

4. Procédé de préparation d'une plaque d'impression pour impression offset inverse, le procédé consistant:

à former au moins une configuration du masque sur un substrat; et
à graver le substrat en utilisant la configuration du masque,
où la configuration du masque est l'image inverse de la configuration de l'encadrement, et
la profondeur (D) de la partie gravée satisfait les Equations 1 et 2 suivantes par rapport à un blanchet pour l'impression offset inverse,
la largeur de ligne (W) de la configuration satisfait l'Equation 3 suivante,
la profondeur (D) est comprise entre 20 $\mu$m et 200 $\mu$m, et
la largeur de ligne (W) est comprise entre 300

$\mu$m et 5 cm:

Equation 1]
$$t < d < D$$

[Equation 2]
$$t = t_{max} - t_{min},$$

[Equation 3]
$$W = 2D + W_0$$

dans l'Equation 1, t représente l'écart de l'épaisseur d'un blanchet, d représente la valeur du déplacement de l'épaisseur du blanchet par la pression d'impression du blanchet, et D représente la profondeur de gravure de la partie en creux, et aussi
dans l'Equation 2, $t_{max}$ représente l'épaisseur maximum du blanchet et $t_{min}$ représente l'épaisseur minimum du blanchet,
dans l'Equation 3, W représente la largeur de ligne de la configuration, D représente la profondeur de gravure d'une partie en creux et $W_0$ représente une largeur de ligne de l'ouverture de la configuration du masque.

5. Procédé selon la revendication 4, où la configuration du masque est formée en un matériau comprenant un ou deux matériaux ou bien davantage sélectionnés dans le groupe composé de chrome, de nickel, de molybdènes, d'un oxyde de ces matériaux et d'un nitrure de ces matériaux.

【Figure 1】

【Figure 2】

EP 2 874 178 B1

【Figure 3】

100    110    112

11

【Figure 4】

【Figure 5】

【Figure 6】

【Figure 7】

Max Deformation value of blanket thickness whthin intaglio portion region

【Figure 8】

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007261144 A
- US 2009283000 A1
- JP 2010143103 A
- JP 2010089442 A
- KR 20100072969 A